# FASCICULE DE BREVET EUROPEEN

(11) **EP 2 355 153 B1**
(45) Date de publication et mention de la délivrance du brevet: **09.05.2012**
(21) Numéro de dépôt: 11152553.1
(22) Date de dépôt: 28.01.2011
(51) Int. Cl.: H01L 27/02, H01L 27/118, G06F 17/50, H01L 27/085, H01L 21/8234

(54) **Bibliothèque de cellules**
Zellbibliothek
Cell library

(30) Priorité: 09.02.2010 FR 1050891
(43) Date de publication de la demande: 10.08.2011
(73) Titulaire: STmicroelectronics SA, 92120 Montrouge (FR); STMicroelectronics (Crolles 2) SAS, 38920 Crolles (FR); COMMISSARIAT A L'ENERGIE ATOMIQUE ET AUX ENERGIES ALTERNATIVES, 75015 Paris (FR)
(72) Inventeur: Menut, Olivier, 38400, SAINT MARTIN D'HERES (FR); Bergher , Laurent, 38240, MEYLAN (FR); Yesilada, Emek, 38000, GRENOBLE (FR); Trouiller, Yorick, 38000, GRENOBLE (FR); Foussadier, Franck, 38100, GRENOBLE (FR); Bingert, Raphaël, 38920, CROLLES (FR)
(74) Mandataire: de Beaumont, Michel

(56) Documents cités:
- EP-A2- 1 862 926
- US-A1- 2004 041 228
- US-A1- 2005 278 660
- US-B1- 7 441 211
- ROY K ET AL: "Low-power design using multiple channel lengths and oxide thicknesses", IEEE DESIGN & TEST OF COMPUTERS, IEEE SERVICE CENTER, NEW YORK, NY, US LNKD- DOI:10.1109/MDT.2004.1261850, vol. 21, no. 1, 1 janvier 2004 (2004-01-01), pages 56-63, XP011105909, ISSN: 0740-7475

## Description

### Domaine de l'invention

La présente invention concerne une bibliothèque de cellules standard en technologie MOS.

### Exposé de l'art antérieur

Des bibliothèques de cellules standard sont utilisées pour faciliter la conception et la synthèse des circuits intégrés. Chaque cellule correspond à un composant élémentaire (par exemple un transistor MOS) ou à un ensemble de composants remplissant une fonction (par exemple une porte OU, ET, NON OU ou NON ET, un inverseur, un couple de transistors, un amplificateur élémentaire, etc.). Une bibliothèque contient un ensemble de paramètres définissant le schéma de circuit et la topologie, ainsi que les bornes d'entrée et de sortie de chaque cellule. Chaque cellule est en outre définie par des paramètres tels qu'un temps de réponse, une puissance de sortie, etc. Pendant la synthèse d'un circuit intégré, des cellules de la bibliothèque sont sélectionnées, agencées, et interconnectées, pour fournir les fonctions requises du circuit.

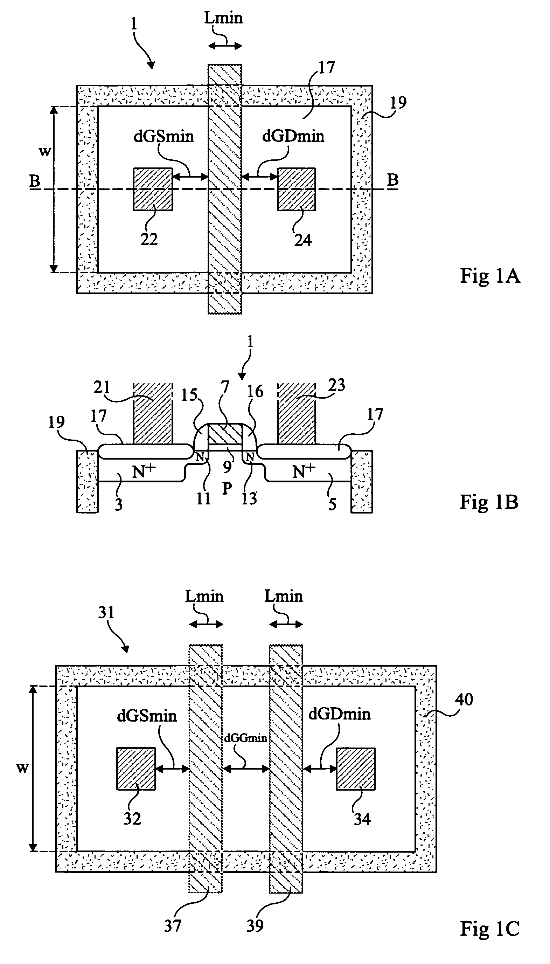

La figure 1A est une vue de dessus représentant de façon très schématique une cellule élémentaire 1 contenant un unique transistor MOS.

La figure 1B est une vue en coupe selon le plan B-B de la cellule 1 de la figure 1A.

Le transistor MOS de la cellule 1, formé dans la partie supérieure d'un substrat semiconducteur de type P, comprend une région de source 3 de type N⁺, et une région de drain 5 de type N⁺, situées de part et d'autre d'une grille 7 isolée du substrat par une couche isolante 9. Des régions 11 et 13 de type N, plus faiblement dopées que les régions 3 et 5, sont formées dans la partie supérieure du substrat sous des espaceurs isolants 15 et 16. La grille 7 a une longueur L et une largeur W. La grille 7 est par exemple en silicium polycristallin et a, en vue de dessus, la forme d'une bande rectangulaire. Les régions de source 3 et de drain 5 sont généralement recouvertes d'une couche de prise de contact en siliciure. L'ensemble de la cellule est délimité par des tranchées d'isolement 19 remplies d'un isolant, par exemple de l'oxyde de silicium, couramment désignées par le sigle STI, de l'anglais "Shallow Trench Isolation" (isolement par tranchées peu profondes). Des vias 21 et 23 viennent en contact avec les régions de siliciure 17 au niveau de zones de contact 22 et 24, et permettent de réaliser des connexions électriques avec les régions de source 3 et de drain 5. Les zones de contact 22 et 24 sont disposées, en vue de dessus, sensiblement au centre des régions de source et de drain.

Dans le cas où le transistor MOS de la cellule 1 doit être un transistor de dimensions minimales dans la technologie considérée, la bibliothèque définit notamment que :
- la longueur de grille Lmin du transistor est la longueur de grille minimale pouvant être réalisée dans la technologie considérée, par exemple de l'ordre de 40 nm ; et
- les distances dGSmin entre la grille 7 et la zone de contact de source 22 et dGDmin entre la grille 7 et la zone de contact de drain 24 sont les plus petites distances réalisables dans la technologie considérée sans risque de court-circuit entre la grille et les zones de contact, par exemple également de l'ordre de 40 nm.

Ceci permet d'obtenir une vitesse de fonctionnement maximale du transistor et une consommation minimale en surface de silicium.

La figure 1C est une vue de dessus représentant de façon très schématique une autre cellule standard 31 de la bibliothèque. La cellule 31 comprend deux transistors MOS à source-drain communs. Des zones de contact 32 et 34 sont prévues du côté des régions non communes de drain et de source de la cellule. La cellule 31 comprend deux grilles parallèles 37 et 39, de même longueur Lmin et de même largeur W. Les grilles 37 et 39 sont disposées entre les zones de contact 32 et 34. L'ensemble de la cellule est délimité par des tranchées d'isolement 40. Comme dans la cellule 1 des figures 1A et 1B, les transistors de la cellule 31 sont réalisés aux dimensions minimales de la technologie de fabrication choisie. Dans ce cas, outre les distances minimales entre les zones de contact et les grilles, une distance minimale dGGmin doit être respectée entre les deux grilles pour éviter tout risque de court-circuit. La distance dGGmin est par exemple de l'ordre de 140 nm en technologie CMOS 40 nm (la figure n'est pas représentée à l'échelle).

Un inconvénient des transistors MOS de dimensions minimales et donc de vitesse de fonctionnement maximale est que de tels transistors présentent des courants de fuite relativement élevés. En effet, plus la longueur de grille d'un transistor MOS est faible, plus le courant de fuite qui le traverse à l'état bloqué est important. Il en résulte une augmentation de la consommation du circuit intégré. Pour certains transistors d'un circuit intégré, la vitesse de fonctionnement n'est pas un paramètre critique. Il est donc dommage, pour ces transistors, d'utiliser des cellules conduisant à des courants de fuite élevés.

Une solution évidente consiste à définir, dans la bibliothèque, des cellules supplémentaires dans lesquelles les transistors MOS ont une longueur de grille supérieure à la longueur de grille minimale de la technologie. Ainsi, pour réaliser un même composant, le concepteur peut, lors de la synthèse, choisir entre deux cellules selon qu'il souhaite optimiser la vitesse de fonctionnement des transistors ou la consommation électrique.

Toutefois, augmenter la longueur de grille des transistors implique d'augmenter la surface occupée par la cellule, afin notamment de respecter les distances de garde minimales entre la ou les grilles et les zones de contact de source et de drain. Ainsi, pour un même composant, la bibliothèque définirait deux cellules de tailles différentes, la plus petite étant caractérisée par une vitesse de fonctionnement des transistors plus élevée, et la plus grande par une consommation électrique moindre. Outre le coût en surface de silicium directement lié à l'augmentation des dimensions de certaines cellules, une telle solution présente l'inconvénient de rendre plus difficile le processus de synthèse d'un circuit intégré. En effet, l'augmentation du nombre de cellules de tailles différentes dans la bibliothèque entraîne des difficultés de placement et d'interconnexion. Il en résulte notamment des pertes de surface utile de silicium.

La demande de brevet européen EP1862926 décrit un procédé de conception de circuits intégrés à partir de bibliothèques de cellules, visant à réduire la consommation électrique.

L'article ROY K ET AL : "Low-Power Design Using Multiple Channel Lengths and Oxide Thicknesses" du 1er janvier 2004 (IEEE DESIGN & TEST OF COMPUTER, IEEE SERVICE CENTER, NEW YORK, NY, US, vol.21, no.1) décrit un procédé de conception de transistors MOS visant à réduire leur consommation.

Le brevet américain US7441211 et la demande de brevet américaine US 2004/0041228 visent l'optimisation de transistors MOS.

### Résumé

Ainsi, un objet d'un mode de réalisation de la présente invention est de prévoir une bibliothèque de cellules standard en technologie MOS, palliant au moins en partie certains des inconvénients des bibliothèques de l'art antérieur.

Un objet d'un mode de réalisation de la présente invention est de prévoir une telle bibliothèque comprenant, pour un composant donné, une définition de cellule optimisant la vitesse de fonctionnement des transistors, et une définition de cellule optimisant la consommation électrique, ces deux cellules occupant une surface identique.

Un objet d'un mode de réalisation de la présente invention est de prévoir une telle bibliothèque facile à définir.

Ainsi, un mode de réalisation de la présente invention prévoit une bibliothèque de cellules destinée à être utilisée pour réaliser un circuit intégré, cette bibliothèque définissant une première cellule comprenant un premier transistor MOS de dimensions minimales, et une deuxième cellule comprenant un deuxième transistor MOS à plus faible courant de fuite, dans laquelle la deuxième cellule occupe la même surface que la première cellule, et le deuxième transistor MOS a une grille de même longueur que la grille du premier transistor MOS sur au moins une première largeur dans sa partie centrale, et de longueur supérieure sur au moins une seconde largeur de part et d'autre de la partie centrale.

Selon un mode de réalisation de la présente invention, chacune des première et deuxième cellules comprend deux transistors à source-drain communs à grilles parallèles, et les grilles des transistors de la deuxième cellule sont de même longueur que les grilles des transistors de la première cellule sur ladite au moins une première largeur, et s'étendent, sur ladite au moins une seconde largeur, sur une longueur supérieure vers le côté opposé au côté commun.

Selon un mode de réalisation de la présente invention, les première et deuxième cellules comprennent chacune, de part et d'autre de la ou des grilles, des zones de contact de source/drain disposées de façon centrale.

Un autre mode de réalisation de la présente invention prévoit un circuit intégré comprenant des première et deuxième cellules de la bibliothèque susmentionnée.

Un autre mode de réalisation de la présente invention prévoir un procédé de synthèse d'au moins une partie d'un circuit intégré à partir de la bibliothèque de cellules susmentionnée, ce procédé comprenant, pour chaque transistor MOS du circuit intégré, les étapes suivantes : choisir la première cellule si le transistor MOS est destiné à fonctionner à vitesse maximale ; et choisir la deuxième cellule si le transistor MOS n'est pas destiné à fonctionner à vitesse maximale.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1A, précédemment décrite, est une vue de dessus représentant de façon schématique une cellule standard d'une bibliothèque, contenant un unique transistor MOS ;
la figure 1B, précédemment décrite, est une vue en coupe de la figure 1A ;
la figure 1C, précédemment décrite, est une vue de dessus représentant de façon schématique une cellule standard d'une bibliothèque, contenant une paire de transistors MOS ;
la figure 2A est une vue de dessus représentant de façon schématique une cellule contenant un transistor MOS à courant de fuite réduit ; et
la figure 2B est une vue de dessus représentant de façon schématique une cellule contenant une paire de transistors MOS à courants de fuite réduits.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

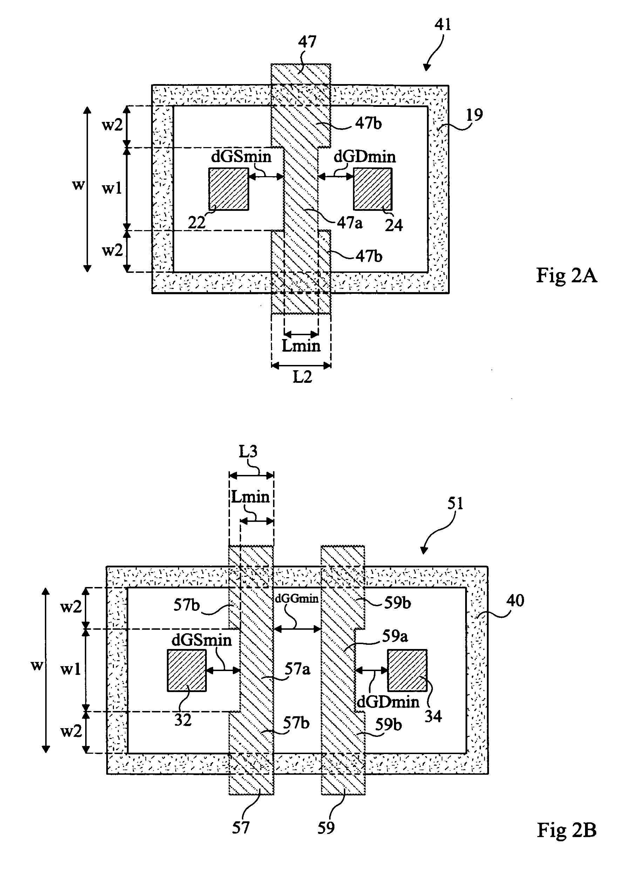

La figure 2A est une vue de dessus représentant de façon schématique un exemple de cellule 41 contenant un unique transistor MOS. La cellule 41 possède de nombreuses similitudes avec la cellule 1 des figures 1A et 1B. Seuls les éléments utiles à la compréhension de l'invention seront décrits à nouveau ici. Comme dans la cellule 1, des vias arrivant sur des zones de contact 22 et 24 permettent de réaliser des connexions électriques avec les régions de source et de drain du transistor de la cellule 41. Les zones de contact 22 et 24 sont disposées, en vue de dessus, sensiblement au centre des régions de source et de drain. Une grille 47, de même largeur W que la grille du transistor MOS de la cellule 1, par exemple de l'ordre de 800 nm, est disposée au dessus du substrat, entre les zones de contact 22 et 24. L'ensemble de la cellule 41 est délimité par des tranchées d'isolement 19 en oxyde de silicium.

La surface occupée par la cellule 41 est identique à la surface occupée par la cellule 1.

Sur une portion centrale 47a de la grille, de largeur W1 inférieure à la largeur totale W, au niveau des zones de contact 22 et 24, la longueur de grille est égale à la longueur de grille minimale Lmin de la technologie, par exemple de l'ordre de 40 nm en technologie CMOS 40 nm. Les distances dGSmin et dGDmin entre la portion 47a de grille et les zones de contact 22 et 24 sont les distances minimales réalisables sans risque de court-circuit, par exemple de l'ordre de 40 nm en technologie CMOS 40 nm.

Du côté de chaque extrémité de la grille 47, sur des portions 47b de largeur W2 telle que W2 + W1 + W2 = W, la grille a une longueur L2 supérieure à Lmin. L2 est par exemple comprise entre 44 et 60 nm dans le cadre d'une technologie CMOS 40 nm, l'allongement de la grille par rapport à Lmin étant équitablement réparti de chaque côté de la grille. Les portions 47b sont suffisamment éloignées des zones de contact 22 et 24 pour que l'augmentation de la longueur de grille laisse une distance de garde suffisante entre tous les points de la grille et les zones de contact.

Ainsi, la cellule 41 équivaut à un transistor MOS de même largeur de grille que le transistor MOS de la cellule 1, et occupe une surface de silicium identique à celle occupée par la cellule 1. Ce transistor a une longueur moyenne de grille supérieure à la longueur de grille du transistor de la cellule 1, d'où il résulte une réduction de son courant de fuite.

On notera qu'il est aisé, à partir de la définition de la cellule 1, de créer une définition de la cellule 41, puisqu'il suffit d'allonger les portions de grille suffisamment éloignées des zones de contact. Les programmes existants de modélisation de cellule sont généralement adaptés à rendre simple cette modification.

La figure 2B est une vue de dessus représentant de façon schématique un autre exemple de cellule 51, contenant une paire de transistors MOS. La cellule 51 possède de nombreuses similitudes avec la cellule 31 de la figure 1C, et certains éléments ne seront pas décrits à nouveau ici.

La cellule 51 comprend une paire de transistors MOS à source-drain communs. Des vias arrivant sur des zones de contact 32 et 34 permettent de réaliser des connexions électriques avec les régions non communes de drain et de source de la cellule. Les zones de contact 32 et 34 sont disposées, en vue de dessus, sensiblement au centre des régions non communes de source et de drain. La cellule 51 comprend deux grilles parallèles 57 et 59 de même largeur W que les grilles de la cellule 31, par exemple de l'ordre de 800 nm. Les grilles 57 et 59 sont disposées entre les zones de contact 32 et 34. L'ensemble de la cellule est délimité par des tranchées d'isolement 40 en oxyde de silicium.

La surface occupée par la cellule 51 est identique à la surface occupée par la cellule 31.

Sur des portions centrales 57a et 59a de la grille, de largeur W1 inférieure à la largeur totale W, sensiblement au niveau des zones de contact 32 et 34, la longueur de grille est égale à la longueur de grille minimale Lmin de la technologie, par exemple de l'ordre de 40 nm en technologie CMOS 40 nm.

Du côté des extrémités des grilles 57 et 59, sur des portions 57b et 59b de largeur W2 telle que W2 + W1 + W2 = W, les grilles ont une longueur L3 supérieure à Lmin. La longueur L3 est par exemple comprise entre 42 et 50 nm, l'allongement des grilles par rapport à Lmin s'étendant uniquement en direction des régions source et drain non communes de la cellule.

Les portions 57b et 59b étant suffisamment éloignées des zones de contact 32 et 34, l'augmentation de la longueur de grille ne risque pas de provoquer des courts-circuits entre la grille et les zones de contact. Aucun allongement des grilles ne peut être effectué en direction de la région source-drain commune car la distance minimale dGGmin (par exemple 140 nm en technologie CMOS 40 nm) entre les deux grilles ne serait alors plus respectée.

Ainsi, dans la cellule 51, les transistors MOS ont une longueur de grille équivalente supérieure à celle des transistors de la cellule 31, et la cellule 51 occupe une surface de silicium identique à celle occupée par la cellule 31.

Plus généralement, un aspect de la présente invention est de prévoir une bibliothèque de cellules comprenant, pour chaque type de cellule, une définition aux dimensions minimales de la technologie, et une définition à courant de fuite réduit dans laquelle certains transistors MOS comprennent des portions de grille plus longues, les cellules formées selon l'une et l'autre des deux définitions occupant une surface de silicium identique.

Un avantage d'une telle bibliothèque est qu'elle permet de synthétiser des circuits intégrés dans lesquels les transistors non critiques en termes de rapidité peuvent avoir des courants de fuite réduits. Le concepteur pourra choisir l'une ou l'autre des deux définitions de cellule en fonction des exigences de la portion de circuit concernée. Les deux cellules occupant des surfaces identiques, ce choix laissé au concepteur ne complexifie pas le processus de placement et d'interconnexion des cellules.

Des modes de réalisation particuliers de la présente invention ont été décrits. Diverses variantes et modifications apparaîtront à l'homme de l'art. En particulier, on a décrit ci-dessus deux types de cellules comprenant des transistors MOS. L'invention ne se restreint pas à ces exemples particuliers, et pourra être mise en oeuvre pour d'autres types de cellules comprenant des transistors MOS.

Par ailleurs, on a proposé ci-dessus, à titre illustratif, des exemples de dimensions de cellules, dans le cadre d'une technologie CMOS 40 nm. L'invention ne se restreint pas à ce cas particulier. L'homme de l'art saura mettre en oeuvre le fonctionnement recherché en utilisant d'autres technologies et d'autres dimensions.

## Revendications

1. Bibliothèque de cellules destinée à être utilisée pour réaliser un circuit intégré, cette bibliothèque définissant une première cellule (1 ; 31) comprenant un premier transistor MOS de dimensions minimales ayant la longueur de grille minimale (L min), et une deuxième cellule (41 ; 51) comprenant un deuxième transistor MOS à plus faible courant de fuite, dans laquelle la deuxième cellule occupe la même surface que la première cellule, **caractérisée en ce que** le deuxième transistor MOS a une grille (47 ; 57, 59) de même longueur (Lmin) que la grille (7 ; 37, 39) du premier transistor MOS sur au moins une première largeur (W1) dans sa partie centrale, et de longueur (L2 ; L3) supérieure sur au moins une seconde largeur (W2) de part et d'autre de la partie centrale.

2. Bibliothèque selon la revendication 1, dans laquelle chacune des première (31) et deuxième (51) cellules comprend deux transistors à source-drain communs à grilles parallèles (37, 39 ; 57, 59), dans laquelle les grilles (57, 59) des transistors de la deuxième cellule sont de même longueur (Lmin) que les grilles (37, 39) des transistors de la première cellule sur ladite au moins une première largeur (W1), et s'étendent, sur ladite au moins une seconde largeur (W2), sur une longueur (L3) supérieure vers le côté opposé au côté commun.

3. Bibliothèque selon la revendication 1 ou 2, dans laquelle les première et deuxième cellules comprennent chacune, de part et d'autre de la ou des grilles, des zones de contact de source/drain (22, 24 ; 32, 34) disposées de façon centrale.

4. Circuit intégré comprenant des première et deuxième cellules de la bibliothèque selon l'une quelconque des revendications 1 à 3.

5. Procédé de synthèse d'au moins une partie d'un circuit intégré à partir d'une bibliothèque de cellules selon l'une quelconque des revendications 1 à 3, ce procédé comprenant, pour chaque transistor MOS du circuit intégré, les étapes suivantes :
choisir la première cellule si le transistor MOS est destiné à fonctionner à vitesse maximale ; et
choisir la deuxième cellule si le transistor MOS n'est pas destiné à fonctionner à vitesse maximale.

## Claims

1. A cell library intended to be used to form an integrated circuit, this library defining a first cell (1; 31) including a first MOS transistor of minimum dimensions having the minimum gate length (Lmin), and a second cell (41; 51) including a second MOS transistor of lower leakage current, wherein the second cell takes up the same surface area as the first cell, **characterized in that** the second MOS transistor has a gate (47; 57, 59) of same length (Lmin) as the gate (7; 37, 39) of the first MOS transistor across at least a first width (W1) in its central portion, and of greater length (L2; L3) across at least a second width (W2) on either side of the central portion.

2. The library of claim 1, wherein each of the first (31) and second (51) cells comprises two transistors having the same source-drain with parallel gates (37, 39; 57, 59), wherein the gates (57, 59) of the transistors of the second cell are of same length (Lmin) as the gates (37, 39) of the transistors of the first cell across said at least a first width (W1), and extending, across said at least a second width (W2), along a greater length (L3) towards the side opposite to the common side.

3. The library of claim 1 or 2, wherein the first and second cells each comprise, on either side of the gate(s), source/drain contact areas (22, 24; 32, 34) arranged at the center.

4. An integrated circuit comprising first and second cells of the library of any of claims 1 to 3.

5. A method for synthesizing at least a portion of an integrated circuit based on the cell library of any of claims 1 to 3, the method comprising, for each MOS transistor of the integrated circuit, the steps of:
selecting the first cell if the MOS transistor is intended to operate at maximum speed; and
selecting the second cell if the MOS transistor is not intended to operate at maximum speed.

## Patentansprüche

1. Eine zur Formung einer integrierten Schaltung verwendbare Zellenbibliothek, wobei diese eine erste Zelle (1; 31) und eine zweite Zelle (41; 51) definiert, wobei die erste Zelle einen ersten MOS Transistor minimaler Dimensionen mit der minimalen Gate-Länge (Lmin) aufweist, und wobei ferner die zweite Zelle einen zweiten MOS Transistor mit niedrigerem Leck-Strom aufweist, wobei die zweite Zelle das gleiche Oberflächengebiet wie die erste Zelle einnimmt,
**dadurch gekennzeichnet, dass** der zweite MOS Transistor ein Gate (47; 57; 59) der gleichen Länge (Lmin) wie das Gate (7; 37, 39) des ersten MOS Transistors über mindestens eine erste Breite (W1) in seinem Mittelteil aufweist und eine größere Länge (L2; L3) über mindestens eine zweite Breite (W2) auf der einen oder anderen Seite des Mittelteils.

2. Die Zellenbibliothek nach Anspruch 1, wobei jede der ersten (31) und zweiten (51) Zellen zwei Transistoren mit gemeinsamer Source-Drain mit parallelen Gates (37, 39; 57, 59) aufweist,
wobei die Gates (57, 59) der Transistoren der zweiten Zelle die gleiche Länge (Lmin) haben wie die Gates (37, 39) der Transistoren der ersten Zelle und zwar über die erwähnte mindestens eine erste Breite (W1), und sich über die erwähnte mindestens zweite Breite (W2) erstreckend und zwar entlang einer größeren Länge (L3) zu der Seite entgegengesetzt zu der gemeinsamen Seite.

3. Die Zellenbibliothek nach Anspruch 1 oder 2, wobei die ersten und zweiten Zellen jeweils auf jeder Seite der Gate(s) Source/Drain-Kontaktgebiete (22, 24; 32, 34) aufweisen, und zwar angeordnet an der Mitte.

4. Eine integrierte Schaltung, die die ersten und zweiten Zellen der Bibliothek irgendeiner der Ansprüche 1 bis 3 aufweist.

5. Verfahren zur Synthetisierung von mindestens eines Teils einer integrierten Schaltung basierend auf der Zellenbibliothek irgendeines der Ansprüche 1 bis 3, wobei das Verfahren für jeden MOS-Transistor der integrierten Schaltung, die folgenden Schritte aufweist:
Auswahl der ersten Zelle wenn der MOS-Transistor mit maximaler Geschwindigkeit arbeiten soll; und
Auswahl der zweiten Zelle wenn der MOS-Transistor nicht mit maximaler Geschwindigkeit arbeiten soll.
